# EUROPÄISCHE PATENTSCHRIFT

(11) **EP 0 627 764 B1**
(45) Veröffentlichungstag und Bekanntmachung des Hinweises auf die Patenterteilung: **23.02.2000**
(21) Anmeldenummer: 94106979.1
(22) Anmeldetag: 04.05.1994
(51) Int. Cl.: H01L 21/78

(54) **Verfahren zur Vereinzelung von Chips aus einem Wafer**
Process for the separation of chips from a wafer
Procédé de séparation des puces d'une plaquette

(30) Priorität: 27.05.1993 DE 4317721
(43) Veröffentlichungstag der Anmeldung: 07.12.1994
(73) Patentinhaber: SIEMENS AKTIENGESELLSCHAFT, 80333 München (DE)
(72) Erfinder: Neppl, Franz, Dr., D-85521 Ottobrunn (DE)

(56) Entgegenhaltungen:
- EP-A- 0 085 607
- EP-A- 0 303 390
- EP-A- 0 325 704
- FR-A- 2 639 149
- US-A- 5 071 792

## Beschreibung

Die vorliegende Erfindung betrifft ein Verfahren zur Vereinzelung von Chips aus einem Wafer gemäß den im Oberbegriff des Patentanspruchs 1 angegebenen Merkmalen.

Nach dem Abschluß der Herstellung von IC-Chips auf einem Wafer müssen die kompletten Scheiben in diese einzelnen Chips zerlegt werden. Zu diesem Zweck werden die Wafer gedünnt, auf Träger geklebt, mit Diamantsägen entlang von sogenannten Sägerahmen zersägt, vom Trägersubstrat gelöst und gereinigt. Für diese Arbeiten können nicht die für die IC-Fertigung vorgesehenen Ausrüstungen verwendet werden, sondern es sind spezielle Ausrüstungen wegen der nicht kompatiblen Verfahrensschritte erforderlich. Die sich ergebenden Sägekanten sind rauh, und das Verfahren erzeugt erhebliche Dichten kleiner Partikel, die beim Sägen entstehen. Diese Partikel setzen sich auf den Chips ab und können bei der Weiterverwendung der Chips z. B. in hochintegrierten Mikrosystemen wie MCMs hinderlich sein.

In der US 5,071,792 ist ein Verfahren zur Herstellung besonders dünner integrierter Halbleiterchips beschrieben. Bei dem dort anhand der Figuren 15 bis 19 beschriebenen Ausführungsbeispiel wird ein SOI-Substrat verwendet, in dessen Body-Siliziumschicht die Chips ausgebildet sind. Zwischen den zu isolierenden Chips werden Gräben bis zur Isolationsschicht des Substrates hin geätzt. Die Gräben werden mit Wachs gefüllt, mit dem der Wafer auf einem Träger befestigt wird. Sodann wird das Silizium des Substratkörpers (Bulk-Silizium) vollständig entfernt. Die Isolationsschicht fungiert dabei als Stopschicht. Danach wird die Isolationsschicht weggeätzt und das Wachs geschmolzen, so daß die Chips vereinzelt werden.

Aufgabe der vorliegenden Erfindung ist es, ein vereinfachtes Verfahren zur Vereinzelung von Chips aus einem Wafer gemäß dem Oberbegriff des Patentanspruches 1 anzugeben, das insbesondere bei Silizium-Wafern mit den Ausrüstungen der Standard-IC-Fertigung der Silizium-Prozeßtechnik einfach ausführbar ist.

Diese Aufgabe wird mit dem Verfahren mit den Merkmalen des Anspruches 1 gelöst. Weitere Ausgestaltungen ergeben sich aus den abhängigen Ansprüchen.

Bei dem erfindungsgemäßen Verfahren werden zwischen den einzelnen Chips Gräben geätzt. Nachdem ggf. Bereiche an der Oberfläche der Chips passiviert wurden, wird das Material, das die Chips trägt, entfernt, z. B. weggeätzt. Dabei werden die einzelnen Chips frei. Die Vorteile dieses Verfahrens sind dadurch gegeben, daß die Grabenätzung im Rahmen der üblichen Technologie erfolgen kann. Es entfällt die Erzeugung von störenden Partikeln, und die Kanten der Chips werden glatt, unter Umständen auch abgerundet. Daraus ergibt sich eine ideale Ausgangssituation für die Weiterverarbeitung der Chips z. B. bei kubischer Integrationstechnik. Es sind beliebige Chipformen möglich, z. B. auch kreisförmige Grundflächen. Beliebige Kombinationen von Chips auch bei dichtester Packung auf einem Wafer sind möglich, da Einschränkungen durch geradlinig durchlaufende Sägelinien entfallen. Die Trennbereiche zwischen den Chips können bei dem erfindungsgemäßen Verfahren sehr klein gehalten werden, weil die Trenngräben sehr schmal geätzt werden können. Fur das Zersägen der Chips sind wesentlich breitere Trennränder von typisch 100 µm erforderlich, während die Gräben in einer Breite von 2 bis 5 µm geätzt werden können. Damit ergibt sich eine erhebliche Reduktion des Platzbedarfes auf dem Wafer, weil ein größerer Anteil der Fläche für die Chips verwendet werden kann und die Zwischenbereiche sehr viel schmaler sind. Dieser positive Effekt wirkt sich vor allem bei kleinen IC's, wie z. B. HF-Bipolarchips aus.

Besonders vorteilhaft läßt sich das erfindungsgemäße Verfahren einsetzen bei Verwendung von SOI-Substraten. Die Chips werden in der Siliziumschicht eines SOI-Substrates hergestellt. Die die einzelnen Chips voneinander trennenden Gräben werden in dieser Siliziumschicht bis auf die Isolationsschicht des SOI-Substrates geätzt. Durch diese Gräben kann dann von oben die Isolationsschicht weggeätzt werden. Eventuell durch die Gräben freigelegte SiO₂-Bereiche, die Teile der Chips bilden, können vor dem Wegätzen der Isolationsschicht, die üblicherweise ebenfalls SiO₂ ist, geeignet passiviert werden.

Es folgt eine Beschreibung des erfindungsgemäßen Verfahrens anhand der beiden Figuren, die eine Anordnung der Chips auf einem SOI-Substrat mit den geätzten Gräben zeigen. Wesentlicher Punkt bei der Realisierung des erfindungsgemäßen Verfahrens ist eine tiefe Grabenätzung an den Rändern der Chips. Mit Breiten von 2 bis 5 µm sind dabei Tiefen der Gräben von etwa 40 µm möglich. Diese Tiefe der Gräben entspricht etwa der angestrebten Dicke der Chips. Die Graben können vorübergehend, z. B. zur Stabilisierung des Wafers während eines zusätzlichen Schrittes zum Dünnen des Substrates, mit einer Hilfsschicht gefüllt werden, die später wieder entfernt wird.

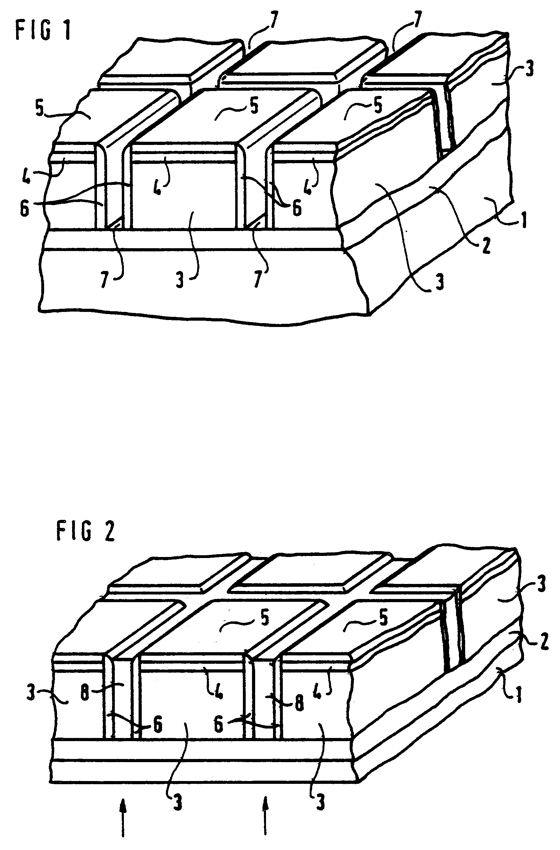

Fig. 1 zeigt auf einem SOI-Substrat 1 in der auf der Isolationsschicht 2 befindlichen Siliziumschicht hergestellte Chips 3, die voneinander getrennt, d. h. vereinzelt werden sollen. Die Dicke der Chips entspricht in etwa der ursprünglichen Schichtdicke der Siliziumschicht des SOI-Substrates. Hier und insbesondere in den Ansprüchen ist unter SOI-Substrat ein Substrat zu verstehen, bei dem eine dünne Siliziumschicht auf einer Isolationsschicht aufgebracht ist. Derartige SOI-Substrate können auch durch SIMOX oder Wafer-bonding hergestellt sein. Die Isolationsschicht 2 ist üblicherweise SiO₂.

Als Beispiel sind in den Chips 3 der Fig. 1 jeweils SiO₂-Schichten 4 eingezeichnet, die zur Oberfläche hin durch Passivierungsschichten 5 abgedeckt sind. Nachdem die Gräben 7 zum Trennen der Chips bis zur Isolationsschicht 2 hin geätzt wurden, werden an den Seiten der Chips 3 Spacer 6 hergestellt, die die SiO₂-Schicht 4 nach außen schützen. Diese Spacer 6 sind z. B. SiN. Diese Spacer werden z. B. in üblicher Weise aufgebracht, indem zunächst das SiN ganzflächig isotrop aufgebracht und anschließend anisotrop rückgeätzt wird. Diese zusätzliche Passivierung kann auch entfallen, wenn keine SiO₂-Bereiche in den Chips 3 offenliegen. Ebenso kann diese Passivierung bereits in dem Standard-Prozeß zur Herstellung der IC's hergestellt werden, z. B. indem die SiO₂-Bereiche in den Chips lokal begrenzt und lateral von SiN oder ähnlichem Material umgeben werden.

Das erfindungsgemäß Verfahren sieht vor, nach dem Ätzen der Graben das Material des Wafers z. B. durch Schleifen oder Ätzen von der Rückseite her zu entfernen, bis die Gräben freigelegt sind und die Chips dadurch vereinzelt werden. Der Wafer wird bei diesem Prozeß gedünnt, bis nur noch die einzelnen Chips übrig sind. Um den Wafer während dieses Dünnens zu stabilisieren, wird in die ausgeätzten Gräben ein Füllmaterial eingebracht, das am Schluß durch Ätzen entfernt wird, wie in 2 dargestellt. Bei dem Wafer der Figur 2 handelt es sich wieder um ein SOI-Substrat mit einer Isolationsschicht 2 auf einem einkristallinen Siliziumkörper 1. Das Abtragen des Materiales dieses Siliziumkörpers 1 von der Rückseite her ist durch die Pfeile angedeutet. Bei der Erfindung wurden die ausgeätzten Gräben vor diesem Dünnerätzen des Wafers mit einem Füllmaterial 8 zur Stabilisierung aufgefüllt. Das SOI-Substrat wird mindestens bis zu der Isolationsschicht 2 hin entfernt. Die Isolationsschicht 2 kann entweder selektiv abgeätzt werden, oder sie wird durch einen ganzflächigen Ätzangriff zusammen mit dem Füllmaterial 8 entfernt. Dieses Füllmaterial 8 ist aus demselben Material wie die Isolationsschicht 2, z. B. SiO₂. Das Füllmaterial kann von den Chips wieder durch zuvor aufgebrachte Spacer 6 zur Passivierung aus SiN oder Polysilizium getrennt werden. Wenn auf das Füllmaterial 8 verzichtet wird, sind die Chips vereinzelt, sowie das die Chips tragende Material (Isolationsschicht 2) vollständig abgetragen ist.

## Patentansprüche

1. Verfahren zur Vereinzelung von Chips aus einem Wafer,
bei dem als Wafer ein SOI-Substrat, bestehend aus einem Substrat (1), einer Isolationsschicht (2) und einer Siliziumschicht (3), verwendet wird,
bei dem die Chips (3) in der Siliziumschicht dieses SOI-Substrates hergestellt werden,
bei dem bis zur Isolationsschicht (2) des SOI-Substrates reichende Gräben (7) zwischen den Chips (3) geätzt werden, die geätzten Gräben (7) mit Füllmaterial (8) aufgefüllt werden, dann der Wafer von der den Chips gegenüberliegenden Seite her mindestens bis zu der Isolationsschicht (2) hin gedünnt wird, und dann die Isolationsschicht und dieses Füllmaterial (8) entfernt werden,
**dadurch gekennzeichnet,**
daß die Gräben (7) mit dem gleichen Material wie die Isolationsschicht (2) als Füllmaterial aufgefüllt werden, daß die Isolationsschicht (2) durch selektives Ätzen entfernt wird, und daß das Füllmaterial ebenfalls durch Ätzen entfernt wird, so daß die Chips vereinzelt werden.

2. Verfahren nach Anspruch 1,
bei dem die freien Oberflächen der Chips nach dem Ätzen der Gräben (7) mit einer Passivierung (5), bezüglich der das Material der Isolationsschicht (2) selektiv geätzt werden kann, bedeckt werden, wobei die Gräben (7) nicht mit der Passivierung (5) gefüllt werden.

## Claims

1. Process for the separation of chips from a wafer,
in which an SOI substrate, comprising a substrate (1), an insulation layer (2) and a silicon layer (3), is used as the wafer,
in which the chips (3) are fabricated in the silicon layer of this SOI substrate,
in which trenches (7) reaching down to the insulation layer (2) of the SOI substrate are etched between the chips (3), the etched trenches (7) are filled with filling material (8), the wafer is then thinned, from the side opposite to the chips, at least as far as towards the insulation layer (2), and the insulation layer and the said filling material (8) are then removed,
characterized
in that the trenches (7) are filled with the same material as the insulation layer (2) as filling material, in that the insulation layer (2) is removed by selective etching, and in that the filling material is likewise removed by etching, so that the chips are separated.

2. Process according to Claim 1,
in which the free surfaces of the chips, after the etching of the trenches (7), are covered with a passivation layer (5), with respect to which the material of the insulation layer (2) can be etched selectively, the trenches (7) not being filled with the passivation layer (5).

## Revendications

1. Procédé de séparation de puces d'une plaquette,
dans lequel on utilise comme plaquette un substrat SOI constitué d'un substrat (1), d'une couche (2) d'isolation et d'une couche (3) de silicium, dans lequel on prépare les puces (3) dans la couche de silicium de ce substrat SOI,
dans lequel on ménage par attaque chimique entre les puces (3) des sillons (7) allant jusqu'à la couche (2) d'isolation du substrat SOI, on remplit les sillons (7) ainsi obtenus par de la matière (8) de charge, puis on amincit au moins jusqu'à la couche (2) d'isolation la plaquette du côté opposé aux puces et ensuite on enlève la couche d'isolation et cette matière (8) de charge,
caractérisé
en ce que l'on remplit les sillons (7) d'une matière de charge qui est en la même matière que la couche (2) d'isolation, en ce qu'on enlève la couche (2) d'isolation par attaque chimique sélective et en ce que l'on enlève également par attaque chimique la matière de charge de manière à séparer les puces.

2. Procédé suivant la revendication 1,
dans lequel les surfaces libres des puces sont revêtues après l'attaque chimique des sillons (7) d'une passivation (5) par rapport à laquelle la matière de la couche (2) d'isolation peut être attaquée chimiquement de manière sélective, les sillons (7) n'étant pas emplis de la passivation (5).
